# EUROPEAN PATENT APPLICATION

(11) **EP 0 528 367 A1**
(43) Date of publication of application: **24.02.1993**
(21) Application number: 92113849.1
(22) Date of filing: 13.08.1992
(51) Int. Cl.: H01L 25/065

(54) **Three-dimensional multi-chip module**

(30) Priority: 13.08.1991 JP 202089/91
(71) Applicant: FUJITSU LIMITED, Kawasaki-shi, Kanagawa 211 (JP)
(72) Inventor: Mizukoshi, Masataka, c/o Fujitsu Limited, Kawasaki-shi, Kanagawa, 211 (JP)
(74) Representative: Schmidt-Evers, Jürgen, Dipl.-Ing.

(57) **Abstract**

A three-dimensional multi-chip module having a high integration density and a high power output in accordance with the present invention comprising:
a substrate (2) having wiring patterns with a plurality of electrode terminals (21), at least a single semiconductor element (10a) arranged facedown on the bottom surface of the substrate (2) and operatively connected to the electrode terminals (21), at least a single semiconductor element (10b) and/or passive element (6) arranged on the front surface of the substrate (2) and operatively connected to the electrode terminals (21), a heat conductive base (4) facing the bottom surface of the substrate (2) and thermally in contact with the back surface of the semiconductor element (2) arranged on the bottom surface of the substrate (2), a support base (3), a cap (7) and a heat sink (5), thereby the heat conductive base (4), the support base (3) and the cap (7) forming an enclosure of the substrate (2).

## Description

### BACKGROUND OF THE INVENTION

### 1. Field of the Invention

The present invention relates to a three-dimensional multi-chip module comprising a plurality of semiconductor chips, and more particularly to the structure of a multi-chip module which achieves a higher integration density and a high power output.

### 2. Description of the Related Art

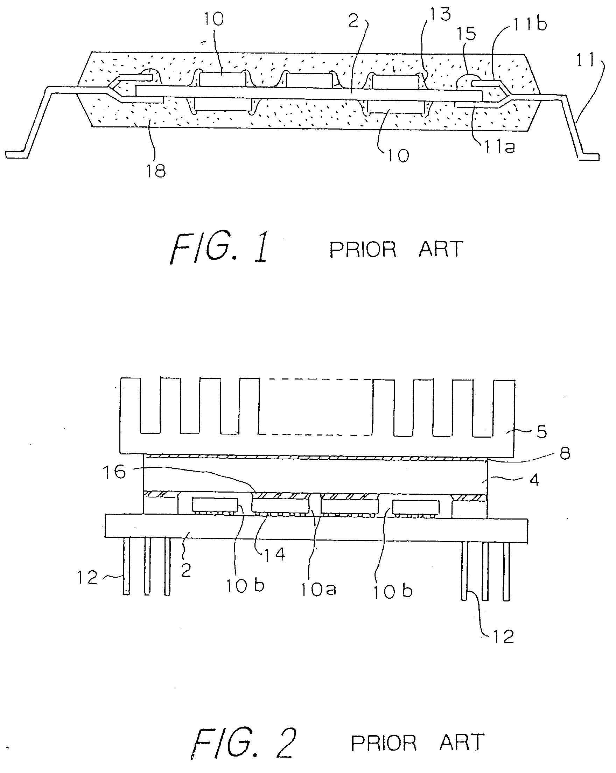

The most typical three-dimensional multi-chip module of the prior art is schematically illustrated in Figure 1. A plurality of semiconductor elements (chips) 10 are arranged on both surfaces of a substrate 2. Wiring patterns and electrode terminals (not shown) are formed in advance on the surfaces of the substrate 2, and bonding pads formed on each semiconductor element 10 are operatively connected to electrode terminals of the wiring patterns by bonding wires 13. The substrate 2 with semiconductor elements 10 is disposed on a stage 11a of a lead frame 11, and electrode terminals of the wiring pattern are operatively connected by boding wires 15 to inner leads 11b of the lead frame 11. Thus formed subassembly is molded in a mold package 18 of epoxy resin.

In order to obtain a higher integration density in a multi-chip module, a wireless bonding method has been utilized. As the wireless bonding method, a flip-chip method, a beam lead method and a TAB (tape automated bonding) method are widely known. Among these methods, the flip-chip method is most effective for saving bonding area on the surface of a substrate.

When the multi-chip module includes a semiconductor element which dissipates a lot of heat during operation, there arises another problem how to give off the heat generated in the semiconductor element out of the multi-chip module. Figure 2 shows an example of a multi-chip module of the prior art, in which the multi-chip module comprises two high output power semiconductor elements 10a. The multi-chip module further comprises two semiconductor elements 10b heat dissipation of which is comparatively small. All semiconductor elements 10a, 10b are bonded facedown to a substrate 2 by the flip-chip bonding method, namely, bumps 14 of solder are formed in advance on the major surface of the semiconductor elements and the semiconductor elements are disposed on the substrate 2, thereby the bumps on the major surface being brought in contact with electrode terminals of wiring pattern (not shown) on the substrate 2 and bonded together, and the wiring pattern being connected to outer leads 12. The back surface of the high power semiconductor elements 10a is further made in contact with a heat conductive base 4 using heat conductive paste 16 therebetween. After fixing a heat sink 5 to the above package, the multi-chip module is finally completed.

The package structure of the prior art of Figure 2 encloses semiconductor elements which are arranged two-dimensionally on a front surface of the substrate 2 only. Therefore, an integration density can not be increased to the level of three-dimensional multi-chip module. Further, there is a problem that mixed disposition of the semiconductor elements is difficult, in which one semiconductor element requires wire bonding and the other semiconductor element requires flip-chip bonding.

### SUMMARY OF THE INVENTION

It is an object of the present invention to provide a multi-chip module having a high integration density and a high power output.

It is another object of the present invention to provide a multi-chip module having a higher integration density and a high power output, in which high power semiconductor elements and low power semiconductor elements and/or passive elements are mixed and arranged three-dimensionally on both surfaces of a substrate.

It is still another object of the present invention to provide a three-dimensional multi-chip module which comprises provision for directly removing the heat generated in high power semiconductor elements arranged on one side of a substrate.

It is further object of the present invention to provide the three-dimensional multi-chip module which further comprises provision for indirectly cooling the elements arranged on the other side of the substrate by removing the heat of the substrate.

The above objects are achieved by a three-dimensional multi-chip module of the present invention comprising: a substrate having a first and second surface, and comprising wiring patterns having a plurality of electrode terminals on the first and second surfaces respectively, at least a single semiconductor element arranged facedown on the first surface of the substrate and operatively connected to the electrode terminals on the first surface, at least a single semiconductor element and/or passive element arranged on the second surface of the substrate and operatively connected to the electrode terminals on the second surface, and a heat conductive base facing the first surface of the substrate and thermally in contact with the back surface of the semiconductor element arranged on the first surface of the substrate.

The multi-chip module of the present invention further comprises a support base and a cap, forming an enclosure together with the heat conductive base, and a heat sink fixed to the heat conductive base, which results in achieving a high integration density and a high power of the module.

Other and further objects and advantage of the invention will become more apparent from the following description, reference being had to the accompanied drawings.

### BRIEF DESCRIPTION OF THE DRAWINGS

Figure 1 shows a schematic cross section of a multi-chip module of the prior art in which semiconductor elements are arranged on both surfaces of a substrate and packaged in a resin mold,
Figure 2 shows a schematic cross section of a multi-chip module of the prior art in which semiconductor elements are arranged on a front surface of a substrate only and a heat sink is provided for cooling high power semiconductor elements,
Figure 3 shows a schematic cross section of an embodiment of a three-dimensional multi-chip module of the present invention in which high power and low power semiconductor elements are respectively arranged on bottom and front surfaces of a substrate, and cooling provision are provided for the high power semiconductor elements,
Figure 4 shows a schematic cross section of another embodiment of a three-dimensional multi-chip module of the present invention in which high power semiconductor elements are arranged on a bottom surface and low power semiconductor elements and/or a passive element are arranged on a front surfaces of a substrate,
Figure 5 shows a schematic cross section of still another embodiment of a three-dimensional multi-chip module of the present invention in which provision for cooling a substrate is added to the structure of Figure 4, and
Figure 6 is a schematic side view of a subassembly of the present invention including a substrate and semiconductor elements, wherein the subassembly can be subjected to a preliminary test before it is packaged.

Throughout the drawings, the same reference numerals designate and identify the same or similar parts.

### DETAILED DESCRIPTION OF THE PREFERRED EMBODIMENTS

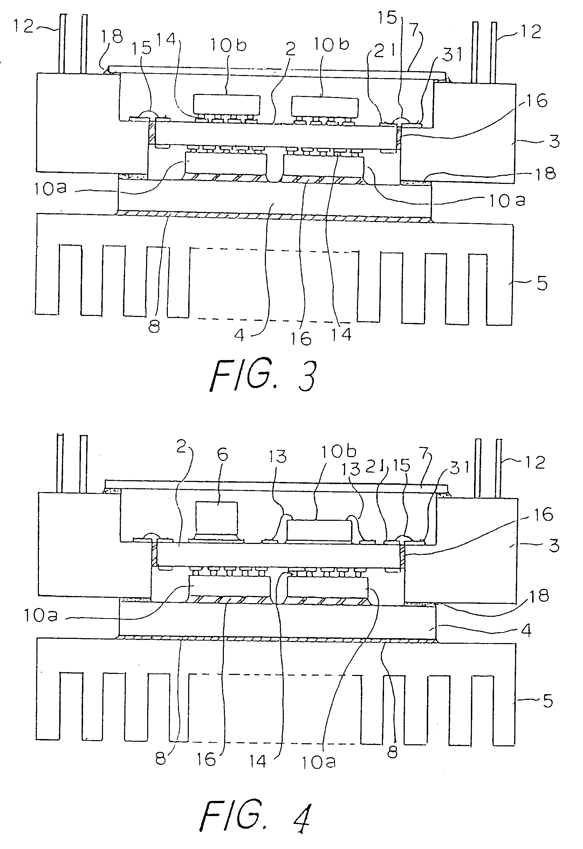

Figure 3 shows a schematic cross section of an embodiment of a three-dimensional multi-chip module in accordance with the present invention.

A support base 3, a heat conductive base 4 and a cap 7 form a packaging enclosure of the multi-chip module, and a substrate 2 with semiconductor elements 10a, 10b is enclosed therein. A heat sink 5 is attached to the heat conductive base 4 and enhances heat handling capability of the multi-chip module.

The substrate 2 is made of multilayer ceramic and predetermined wiring patterns are formed between ceramic layers and/or on the surface of the substrate by the known technology. A plurality of semiconductor elements 10a, 10b are arranged on a first and second surface of the substrate 2, thereby the first surface being defined for the surface which subsequently faces the heat conductive base 4 after packaging. The semiconductor element 10a which requires comparatively large heat dissipation is arranged on the first surface of the substrate 2, and the semiconductor element 10b which requires comparatively small heat dissipation is arranged on the second surface thereof. Therefore, a semiconductor element which dissipates several watts to tens of watts is preferably arranged on the first surface of the substrate 2.

In Figure 3, both semiconductor elements 10a, 10b are bonded facedown to the first and second surfaces of the substrate 2, namely, the major surface comprising main integrated circuits of the semiconductor element is bonded facing the substrate 2. In Figure 3, a flip-chip method is applied for bonding the semiconductor elements 10a, 10b and, in this case, a plurality of bumps 14 which are to be bonded to electrode terminals of the wiring pattern, are formed in advance on the major surface of the semiconductor elements. The semiconductor elements 10a, 10b are disposed at the predetermined positions respectively on the first and second surfaces of the substrate 2 and they are heated for reflowing the solder of the bumps.

A subassembly composed of the semiconductor elements 10a, 10b and the substrate 2 is mounted on another subassembly composed of the support base 3 and the heat conductive base 4, thereby these two parts being fixed together by thermal conductive resin or solder. The support base 3 is made of multilayer ceramic and comprises a buried wiring pattern (not shown) and a plurality of outer leads 12 and a plurality of electrode terminals 31. The outer leads 12 and electrode terminals 31 are operatively connected by the wiring pattern.

The material used for the heat conductive base 4 is required to have a high thermal conductivity and also have a thermal expansion coefficient which is close to that of silicon as much as possible. Porous sintered copper-tungsten (Cu-W) and sintered copper-molybdenum (Cu-Mo) have a thermal expansion coefficient of approx. 6x10⁻⁶/deg, and these materials are favorable as the heat conductive base 4 on which silicon chip (having a thermal expansion coefficient of about 2.6x10⁻⁶/deg) is disposed.

The substrate 2 with semiconductor elements 10a, 10b is mounted on the heat conductive base 4 in a manner that the minor surfaces (back surfaces) of the semiconductor elements 10a are fixed to the heat conductive base 4 using heat conductive adhesive 16 such as Ag paste, solder, etc. between the thermal conductive base 4 and the minor surface of the semiconductor elements 10a, and further the substrate 2 is fixed to the support base 3 using insulating thermal conductive resin therebetween.

Next, electrode terminals 31 on the step portion of the support base 3 and electrode terminals 21 on the substrate 2 are connected by bonding wires 15.

Finally, a heat sink 5 of aluminum or aluminum alloy is fixed on the outer surface of the heat conductive base 4 using thermal compound, and the cap 7 of iron-nickel alloy closes an opening of the support base 3. Thus, the three- dimensional multi-chip module of the embodiment is completed.

Figure 4 shows a schematic cross section of another embodiment of a three-dimensional multi-chip module of the present invention. Semiconductor elements 10a having comparatively a large heat dissipation are arranged facedown on the first surface (bottom surface) of the substrate 2 and bonded thereto in the same way as in Figure 3. On the other hand, semiconductor elements 10b having comparatively a small heat dissipation are arranged faceup on the second surface (front surface) of the substrate 2, and pads (not shown) on the semiconductor element 10b are connected to electrode terminals on the substrate 2 using a bonding wire 13. Further a passive elements 6 such as capacitor, coil, and resistor are arranged on the second surface of the substrate 2 and connected to the electrode terminals on the substrate 2.

Figure 4 shows that active and/or passive elements which require a wire-bonding method can be mixed and comprised in the module using the second surface of the substrate 2.

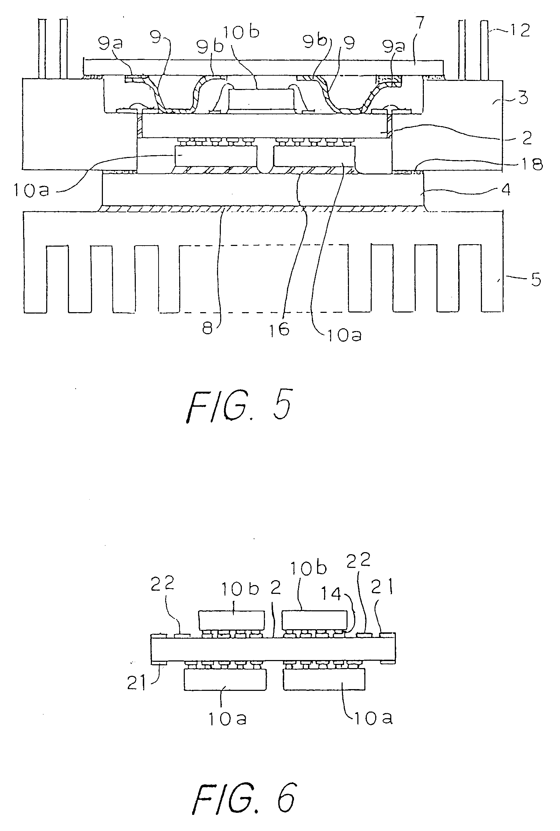

Figure 5 shows a schematic cross section of still another embodiment of the present invention. The only one difference in structure between Figure 4 and Figure 5 exists in that the module of Figure 5 further comprises a heat conductive metal member 9 having elasticity. One end 9a of the metal member 9 is fixed to an inside surface of the cap 7. The other end 9b of the metal member 9 is elastically in contact with the inside surface of the cap 7 and can move when the metal member 9 is subjected to thermal expansion. The middle portion of the metal member 9 is elastically in contact with the second surface of the substrate 2 and pressing the second surface of the substrate 2 when the cap 7 closes the opening of the support base 3.

Since semiconductor elements 10b and/or passive elements 6 arranged on the second surface of the substrate 2 have no direct heat removing means such as the heat conductive base 4 for the semiconductor elements 10a on the first surface of the substrate 2, heats generated in semiconductor elements 10b and passive elements 6 are conducted to the substrate 2. Temperature rise of the substrate 2 can be remarkably reduced by the function of the above metal member 9 by conducting the heat of the substrate 2 to the cap 7 which is cooled by the ambient atmosphere.

The shape of the metal member 9 in Figure 5 shows an illustrative one, and many other shapes can be used. One end of the metal member 9 may be fixed to the substrate 2 and the other end may be in contact with the cap 7 or vice versa, thereby metal member 9 having a "U" character shape being used laying its side up.

Figure 6 shows a schematic cross section of a modified structure of a substrate 2 with semiconductor elements 10a, 10b arranged thereon. Wiring patterns (not shown) on the substrate 2 has test terminals 22 other than electrode terminals 21 which are actually used for bonding the semiconductor elements 10a, 10b and subsequently for connecting the wiring patterns to the outside electrode terminals. Before packaging the substrate 2 having the semiconductor elements 10a, 10b bonded thereto into the multi-chip module, it is desirable that the subassembly of Figure 6 comprising the substrate 2 and the semiconductor elements 10a, 10b bonded thereto, is subjected to function test, in which the entire circuit of the module is divided into several circuit blocks and each circuit block is tested using the test terminals 22 and/or electrode terminals 21.

When any of the circuit blocks is found to be defective, a defective semiconductor element can be easily replaced with a good one. After confirming the subassembly works satisfactory, the substrate 2 with semiconductor elements 10a, 10b is packaged in the enclosure of support base 3, heat conductive base 4 and cap 7. In Figure 6, all semiconductor elements 10a, 10b are bonded facedown to the substrate 2 using bumps 14. A substrate 2 having test terminals 22 can be utilized for other multi-chip module comprising semiconductor elements requiring wire bonding and/or passive elements.

The present invention may be embodied in other specific forms. The presently disclosed embodiments are, therefore, to be considered in all respects as illustrative and not restrictive, the scope of the invention being indicated by the appended claims, rather than the foregoing description, and all changes which come within the meaning and range of equivalence of the claims are, therefore, to be embraced therein.

## Claims

1. A multi-chip module having a plurality of semiconductor elements arranged three-dimensionally, said multi-chip module comprising:
a substrate (2) having a first surface and a second surface, and wiring patterns including a plurality of electrode terminals (21) formed on the first and second surfaces respectively,
at least a single semiconductor element (10a) arranged facedown on the first surface of the substrate (2) and operatively connected to the electrode terminals (21) on the first surface,
at least a single semiconductor element (10b) arranged on the second surface of the substrate (2) and operatively connected to the electrode terminals (21) on the second surface, and
a heat conductive base (4) facing the first surface of the substrate and thermally in contact with a back surface of the semiconductor element (10a) arranged on the first surface of the substrate (2).

2. A multi-chip module as recited in claim 1, said multi-chip module further comprising:
a support base (3) having a plurality of outer leads (12) and a plurality of electrode terminals operatively connected to the outer leads (12) and having an opening for accepting said substrate (2) with the semiconductor elements (10a,10b) therein, thereby the electrode terminals on the support base (3) being operatively connected to said electrode terminals on the substrate (2) and an end surface of the support base (3) being fixed to the periphery of said heat conductive base (4).

3. A multi-chip module as recited in claim 2, said multi-chip module further comprising:
a cap (7) disposed on said support base (3) facing the second surface of the substrate (2), thereby said heat conductive base (4), said support base (3) and the cap (7) forming an enclosure inside which said substrate (2) is disposed.

4. A multi-chip module as recited in anyone of claims 1 to 3, said multi-chip module further comprising:
a heat sink (5) for cooling said heat conductive base (4).

5. A multi-chip module as recited in anyone of claims 1 to 4, wherein said semiconductor element (10a) on the first surface of the substrate (2) is the one whose heat dissipation is large and said semiconductor element (10b) on the second surface is the one whose heat dissipation is small.

6. A multi-chip module as recited in anyone of claims 1 to 5, said multi-chip module further comprising:
a passive element (6) arranged on the second surface of the substrate (2).

7. A multi-chip module as recited in anyone of claims 1 to 6, wherein material of said heat conductive base (4) has a thermal expansion coefficient close to that of the semiconductor element (2).

8. A multi-chip module as recited in anyone of claims 2 to 7, wherein said substrate (2) and said support base (3) are made of ceramic.

9. A multi-chip module as recited in anyone of claims 3 to 8, said multi-chip module further comprising:
an elastic metal member (9) of heat conductive material inserted between the second surface of said substrate (2) and the inside surface of said cap (7).

10. A multi-chip module as recited in claim 9, wherein one and (9a) of said metal member (9) is fixed to the inside surface of the cap (7), the other end (9b) thereof is movable in contact with the inside surface of the cap (7), and the middle portion thereof is in contact with said second surface of the substrate (2).

11. A multi-chip module as recited in anyone of claims 1 to 10, wherein said wiring pattern further comprises test terminals (22), whereby the test terminals (22) are used for testing each circuit block of a subassembly composed of said semiconductor elements (10a,10b) and the substrate (2) before packaging into the multi-chip module.
